# EUROPÄISCHE PATENTSCHRIFT

(11) **EP 0 902 924 B1**
(45) Veröffentlichungstag und Bekanntmachung des Hinweises auf die Patenterteilung: **04.04.2001**
(21) Anmeldenummer: 97930292.4
(22) Anmeldetag: 21.05.1997
(51) Int. Cl.: G06F 11/20

(54) **REDUNDANZSPEICHERVORRICHTUNG MIT ROM-SPEICHERZELLEN**
REDUNDANCY MEMORY CIRCUIT WITH ROM STORAGE CELLS
CIRCUIT MEMOIRE REDONDANT AVEC CELLULES DE MEMOIRE ROM

(30) Priorität: 03.06.1996 DE 19622275
(43) Veröffentlichungstag der Anmeldung: 24.03.1999
(73) Patentinhaber: Infineon Technologies AG, 81669 München (DE)
(72) Erfinder: BERNAUER, Klaus, A-5020 Salzburg (AT); BREILMANN, Jochen, D-40885 Ratingen (DE); BROMBA, Manfred, D-81699 München (DE); MC CONNELL, Roderick, D-81539 München (DE); PLÄTTNER, Eckehard, D-81737 München (DE); SCHÖNEMANN, Konrad, D-80807 München (DE)
(74) Vertreter: Zedlitz, Peter, Dipl.-Inf.
(86) Internationale Anmeldenummer: DE9701016
(87) Internationale Veröffentlichungsnummer: WO9746942

(56) Entgegenhaltungen:
- US-A- 4 601 031
- US-A- 4 782 466

## Beschreibung

Die Erfindung betrifft ein Redundanzkonzept für integrierte Speicherschaltungen mit ROM-Speicherzellen.

Unter (Hardware-)Redundanz bei integrierten Speichern versteht man allgemein das adressenmäßige Ersetzen adressierbarer Einheiten von Speicherzellen innerhalb des Speichers durch redundante Einheiten von Speicherzellen. Dabei können die adressierbaren Einheiten beispielsweise Wort- oder Bitleitungen sein. Der sogenannte Redundanzfall tritt ein, wenn bei einem Test des Speichers festgestellt wird, daß eine der ersetzbaren adressierbaren Einheiten Defekte aufweist. Der Speicher wird dann so manipuliert, daß beim Anlegen der Adresse der zu ersetzenden Einheit nicht diese sondern die redundante Einheit angesprochen wird. Im allgemeinen wird ein entsprechender Speichertest im Anschluß an die Herstellung des Speichers durchgeführt, so daß die Redundanzreparatur direkt anschließend vorgenommen werden kann.

Bei RAM-Speichern (Random Access Memory, Schreib- und Lese-Speicher) ist es üblich, redundante Wort- oder Bitleitungen vorzusehen, die ebenfalls RAM-Speicherzellen wie die "normalen" Wort- und Bitleitungen aufweisen.

Eine Möglichkeit, Redundanz bei einem ROM-Speicher (Read Only Memory, Nur-Lese-Speicher) vorzusehen, beschreibt die US-A 5,388,076. Dort ist gezeigt, daß defekte ROM-Speicherzellen durch redundante programmierbare ROM-Speicherzellen (PROM-Speicherzellen, Programmable ROM) ersetzt werden, die im Redundanzfall durch trennbare Verbindungen (fuses) so programmiert werden, daß sie anschließend die in den zu ersetzenden Speicherzellen zu speichernden Daten enthalten. Diese Lösung hat den Nachteil, daß die redundanten Speicherzellen als PROM-Speicherzellen relativ groß sind.

In der US-A 4,601,031 ist ein reparierbarer ROM-Speicher beschrieben, bei dem eine defekte Reihe von ROM-Speicherzellen durch eine redundante Reihe mit RAM-Speicherzellen ersetzt wird. Jede Spalte des ROM-Speicherzellenfeldes enthält ein Prüfbit und die in der redundanten Reihe zu speichernden Daten werden mit Hilfe dieses Prüfbits rekonstruiert. Bei der Initialisierung des Speichers werden rekonstruierten Daten in die redundante Reihe geschrieben.

Der Erfindung liegt die Aufgabe zugrunde, eine Speicherschaltung mit ROM-Speicherzellen anzugeben, bei der die redundanten Speicherzellen einen geringen Flächenbedarf haben.

Diese Aufgabe wird durch eine Speicherschaltung nach Anspruch 1 gelöst. Weiterbildungen und Ausgestaltungen der Erfindung sind in den Unteransprüchen gekennzeichnet.

Erfindungsgemäß ist es vorgesehen, "normale" adressierbare erste Einheiten mit ROM-Speicherzellen durch redundante adressierbare zweite Einheiten mit RAM-Speicherzellen zu ersetzen. Die ersten und zweiten Einheiten können dabei z.B. Wort- oder Bitleitungen oder unter Umständen auch ganze Speicherblöcke sein.

Ein Speichertest erfolgt vorzugsweise direkt im Anschluß an den Herstellungsprozeß des Speichers. Anschließend ist das erfindungsgemäße Ersetzen defekter der ersten Einheiten vornehmbar. Um den Speicherzelleninhalt der ersetzten ROM-Speicherzellen in den flüchtigen redundanten RAM-Speicherzellen wiederherzustellen, sieht eine Weiterbildung der Erfindung vor, bei jeder Inbetriebnahme des Speichers (also beim Anlegen der Versorgungsspannung) eine Initialisierung durchzuführen, bei der diese Speicherzelleninhalte rekonstruiert und in den RAM-Speicherzellen gespeichert werden. Diese Initialisierung des Speichers ist mittels eines Prozessors durchführbar.

Die Verwendung redundanter RAM-Speicherzellen weist den Vorteil auf, daß diese kleinflächiger realisierbar sind als PROM-Speicherzellen, die als redundante Speicherzellen bei der oben erwähnten US-A 5,388,076 vorgesehen sind. Dies trifft vor allem zu, wenn es sich um redundante DRAM-Speicherzellen (Dynamic RAM) handelt.

Die Erfindung ist insbesondere in sogenannten DROM-Speichern (Dynamic ROM) von Vorteil (auch die US-A 5,388,076 beschreibt ein DROM), auch wenn sie nicht auf derartige Speicher beschränkt ist. DROMs sind eine Variante eines ROMs und weisen ROM-Speicherzellen auf, die denselben Aufbau und dieselbe Zellstruktur wie DRAM-Speicherzellen haben. Diese ROM-Speicherzellen haben die gleichen elektrischen Komponenten und die gleichen Abmessungen wie RAM-Speicherzellen. Ein DROM ist auf einfache Weise durch geringfügige Veränderung des Herstellungsprozesses eines DRAMs herstellbar und man erzielt so ein ROM mit Speicherzellen, die genauso klein wie DRAM-Speicherzellen sind.

Zumindest ein Teil der ROM-Speicherzellen eines DROMs ist dabei gegenüber normalen DRAM-Speicherzellen in ihrem Aufbau modifiziert: So kann bei einer ersten Realisierungsform beispielsweise die elektrische Verbindung zwischen einem Auswahltransistor und einem Speicherzellenkondensator der DRAM-Speicherzelle bei einer ROM-Speicherzelle vorhanden sein, sofern ein Datum eines ersten logischen Zustandes in der ROM-Speicherzelle gespeichert ist. Zur Speicherung eines Datums eines zweiten logischen Zustandes ist dagegen keine elektrische Verbindung zwischen Auswahltransistor und Speicherzellenkondensator der entsprechenden ROM-Speicherzelle vorhanden. Im Speicherzellenkondensator dieser letztgenannten, modifizierten Speicherzellen kann dann keine Ladung gespeichert werden, so daß bei Auslesen der Speicherzelle über den Auswahltransistor das Potential einer mit dem Auswahltransistor verbundenen Bitleitung nahezu unbeeinflußt bleibt.

Eine zweite Realisierungsform für die ROM-Speicherzellen eines DROMs sieht vor, den normalerweise mit dem Speicherzellenkondensator verbundenen Anschluß des Auswahltransistors mit verschiedenen festen Potentialen zu verbinden, je nachdem welchen logischen Zustand das zu speichernde Datum aufweist (dies ist in der o.g. US-A 5,388,076 gezeigt).

Die Erfindung wird im folgenden anhand der Zeichnungen näher erläutert. Es zeigen:
Figur 1 ein Ausführungsbeispiel der Erfindung,
Figur 2 Details aus Figur 1,
Figuren 3 und 4 weitere Details aus Figur 1 für andere Ausführungsbeispiele der Erfindung.

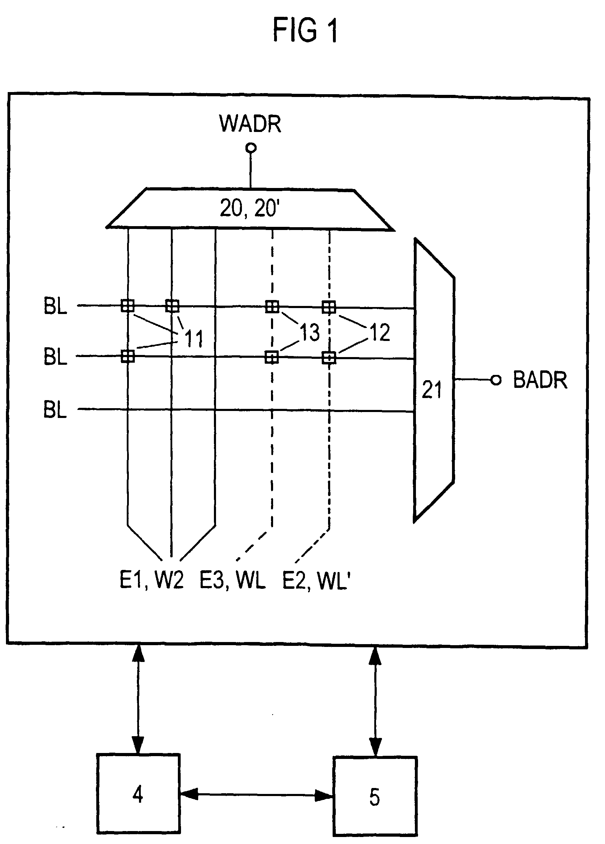

Figur 1 zeigt schematisch einen erfindungsgemäßen integrierten Speicher. Dieser hat Bitleitungen BL, "normale" Wortleitungen WL und redundante Wortleitungen WL', in deren Kreuzungspunkten Speicherzellen 11, 12, 13 angeordnet sind. Eine Adressierung der Wortleitungen WL ist über einen Wortleitungsdekoder 20 und eine Adressierung der redundanten Wortleitungen WL über einen redundanten Wortleitungsdecoder 20 (beide sind in Figur 1 als eine Einheit dargestellt) durchführbar, während die Adressierung der Bitleitungen BL über einen Bitleitungsdekoder 21 erfolgt. Hierfür sind Wortadressen WADR bzw. Bitadressen BADR an die entsprechenden Decoder 20, 20', 21 anlegbar.

Die drei der dargestellten normalen Wortleitungen WL sind jeweils einzeln adressierbare "normale" erste Einheiten E1 mit ROM-Speicherzellen 11. Die ersten Einheiten E1 dienen zum Betrieb des Speichers, sofern keine Redundanz auftritt. Die redundanten Wortleitungen WL sind redundante zweite Einheiten E2 mit RAM-Speicherzellen 12 und dienen im Redundanzfall einem adreßmäßigen Ersetzen je einer der ersten Einheiten E1. Außerdem ist eine der normalen Wortleitungen WL eine dritte adressierbare Einheit E3 mit Festwert-Speicherzellen 13.

Eine Redundanzreparatur wird vorzugsweise direkt nach der Herstellung des integrierten Speichers und nach Durchführung eines Speichertestes vorgenommen. Eine defekte der ersten Einheiten E1 ist dann durch die zweite Einheit E2 adreßmäßig ersetzbar. Zu diesem Zwecke ist der redundante Wortleitungsdecoder 20' entsprechend zu programmieren, was einer herkömmlichen Hardware-Redundanzreparatur entspricht und daher dem Fachmann bekannt ist.

In den Festwert-Speicherzellen 13 der dritten Einheit E3 sind Paritätsbits speicherbar, welche zur Rekonstruktion des Dateninhaltes von fehlerhaften der ROM-Speicherzellen 11 mittels Fehlerkorrekturcodes in einer erweiterten Initialisierungsphase des Speichers bei seiner Inbetriebnahme dienen, wie weiter unten noch erläutert wird. Diese erfindungsgemäße Initialisierung ist bei jeder Inbetriebnahme des Speichers vorzunehmen, da RAM-Speicherzellen bekanntlich flüchtige Speicher sind.

Der erfindungsgemäße Speicher in Figur 1 weist außerdem ein Redundanz-Detektionsmittel 4 und ein Reparaturmittel 5 auf. Mittels des Redundanz-Detektionsmittels 4 sind im Redundanzfall die Adressen von ersetzten der ersten Einheiten E1 ermittelbar. Daraufhin ist durch das Reparaturmittel 5 eine Rekonstruktion bzw. Reparatur der ursprünglich in den ersetzten der ROM-Speicherzellen 11 zu speichernden Daten in der Weise durchführbar, daß diese Daten anschließend in den sie ersetzenden RAM-Speicherzellen 12 gespeichert sind. Nach dem Ersetzen einer der ersten Einheiten E1 im Redundanzfall durch die zweite Einheit E2 ist bei jeder Inbetriebnahme des Speichers eine Initialisierung durchführbar, bei der der Inhalt der flüchtigen, redundanten RAM-Speicherzellen 12 wiederhergestellt wird.

Das Redundanz-Detektionsmittel 4 und das Reparaturmittel 5 können beispielsweise durch einen Mikroprozessor realisiert sein, der die Adreßerkennung fehlerhafter erster Einheiten und die Rekonstruktion der fehlerhaften Daten in den redundanten RAM-Speicherzellen 12 vornimmt. Dieser Prozessor kann auf derselben integrierten Schaltung wie der integrierte Speicher angeordnet sein oder auf einer separaten integrierten Schaltung.

Die Fehlerkorrektur durch das Reparaturmittel 5 ist beispielsweise mittels Fehlerkorrekturcodes unter Zuhilfenahme der in den dritten Einheiten E3 gespeicherten Paritätsbits durchführbar. Die Paritätsbits erlauben die Rekonstruktion einzelner Speicherfehler innerhalb einer der Wortleitungen WL unter Zuhilfenahme der anderen, in den Speicherzellen dieser Wortleitung WL gespeicherten Daten.

Es ist vorteilhaft, die dritten Einheiten E3 mit den Festwert-Speicherzellen 13 im selben Speicherzellenfeld wie die ersten Einheiten E1 anzuordnen. Dann sind die Festwert-Speicherzellen 13 von derselben Speicherzellenart wie die ROM-Speicherzellen 11 (z.B. DROM-Speicherzellen). Es ist aber auch alternativ möglich, daß die dritten Einheiten E3 in einem von den ersten Einheiten E1 getrennten Speicher angeordnet sind.

Statt einzelner Paritätsbits (eine dritte Einheit E3) können auch Paritätssymbole mit mehreren Paritätsbits, z.B. Paritätsbytes vorgesehen sein. Es sind dann mehrere dritte Einheiten E3 vorhanden.

Fehlerkorrekturcodes zur Rekonstruktion von fehlerhaft gespeicherten Daten sind dem Fachmann bekannt und werden hier nicht weiter erläutert. Beispielhaft wird nur der Reed-Solomon-Code und der Hamming-Code genannt.

Nach der Durchführung der Reparatur im Redundanzfall sind also die ursprünglich in den zu ersetzenden ROM-Speicherzellen zu speichernden Daten in den sie ersetzenden RAM-Speicherzellen 12 gespeichert.

Figur 1 zeigt beispielhaft nur wenige normale Wortleitungen WL und eine redundante Wortleitung WL' und wenige Bitleitungen BL. Natürlich weist ein realer Speicher sehr viel mehr derartige Leitungen auf. Außerdem können mehrere dritte Einheiten E3 mit Paritätsbits vorgesehen sein. Die Erfindung ist statt auf Wortleitungsredundanz alternativ oder zusätzlich natürlich auch auf Bitleitungsredundanz anwendbar.

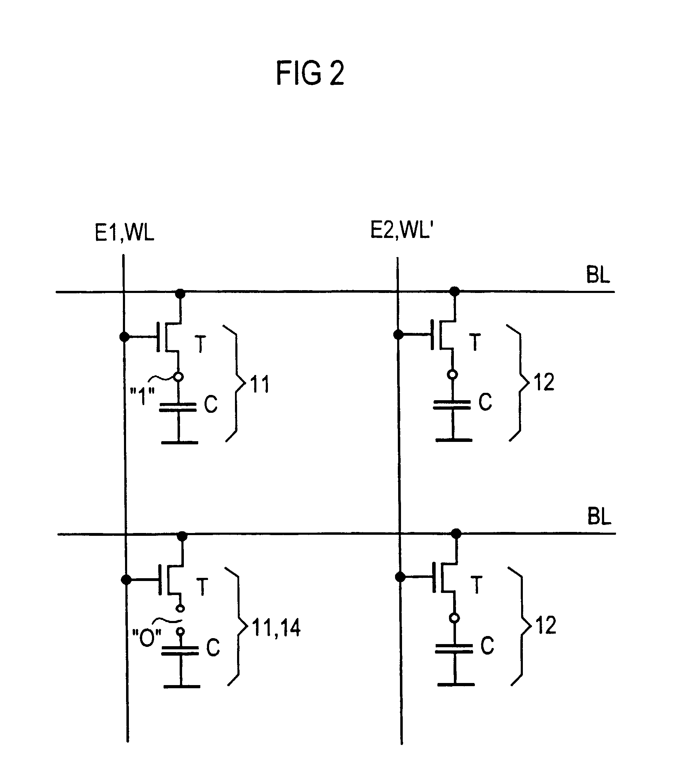

Figur 2 zeigt als Detailansicht eine mögliche Ausführungsform einiger der ROM-Speicherzellen 11 und der RAM-Speicherzellen 12 aus Figur 1. Der besseren Übersicht wegen sind nur zwei der Bitleitungen BL und eine der Wortleitungen WL (erste Einheit E1) sowie nur eine der redundanten Wortleitungen WL' (zweite Einheit E2) dargestellt. Für das dargestellte Ausführungsbeispiel ist angenommen, daß es sich bei dem integrierten Speicher um einen DROM-Speicher handelt.

Der abgebildete Ausschnitt des integrierten Speichers beinhaltet zwei "normale" oder "reguläre" ROM-Speicherzellen 11 und zwei redundante RAM-Speicherzellen 12, die Ein-Transistor-DRAM-Speicherzellen sind. Wie bereits dargelegt, weisen DROMs ROM-Speicherzellen auf, die dieselbe Zellstruktur wie DRAM-Speicherzellen haben. Jede der ROM-Speicherzellen 11 und der RAM-Speicherzellen 12 weist daher einen Auswahltransistor T und einen Speicherzellenkondensator C auf. Über die Wortleitungen WL, WL' werden bei entsprechender Adressierung die Auswahltransistoren T geöffnet und der Inhalt des Speicherzellenkondensators C kann anschließend über die Bitleitungen BL ausgelesen werden.

Die ROM-Speicherzelle 11 links oben in Figur 2 weist eine elektrische Verbindung zwischen dem Auswahltransistor T und dem Speicherzellenkondensator C auf, wie es auch bei den RAM-Speicherzellen 12 der Fall ist. Dagegen ist bei der ROM-Speicherzelle 11 links unten diese Verbindung nicht vorhanden, sie ist eine modifizierte Speicherzelle 14. Das Vorhandensein oder Nicht-Vorhandensein dieser elektrischen Verbindung wird während der Herstellung des integrierten Speichers festgelegt, während die ROM-Speicherzellen 11 - z.B. durch Masken-Programmierung - programmiert, d. h. mit Daten beschrieben werden. Die ROM-Speicherzelle 11 links oben hat angenommenermaßen ein Datum eines ersten logischen Zustandes 1 gespeichert, während die ROM-Speicherzelle 11 links unten (die modifizierte Speicherzelle 14) ein Datum eines zweiten logischen Zustandes 0 gespeichert hat. Dabei soll der erste logische Zustand durch ein hohes Potential und der zweite logische Zustand durch ein niedriges Potential definiert sein.

Nachfolgend wird die Initialisierung des Speichers beschrieben, bei der sowohl (wie bei DROMs bereits bekannt) die Inhalte der intakten ROM-Speicherzellen 11 in diese geladen werden als auch (erfindungsgemäß) eine Rekonstruktion der Inhalte der flüchtigen redundanten RAM-Speicherzellen 12 erfolgt:

Bei der Inbetriebnahme eines DROMs, bei dem die Speicherzellen wie die ROM-Speicherzellen in Figur 2 gestaltet sind, ist, wie bereits erwähnt, bei jeder Inbetriebnahme eine sogenannte "Initialisierung" durchführbar. Dabei sind durch einen Prozessor in alle ROM-Speicherzellen 11 Daten des ersten logischen Zustandes einschreibbar. Dieses Einschreiben gelingt jedoch nur bei denjenigen ROM-Speicherzellen 11, bei denen die Verbindung zwischen dem Auswahltransistor T und dem Speicherzellenkondensator C vorhanden ist. Werden anschließend die ROM-Speicherzellen 11 ausgelesen, erhält man nur bei den letztgenannten, nicht-modifizierten der ROM-Speicherzellen 11 als Ergebnis ein Datum des ersten logischen Zustandes 1. Dagegen beeinflußt der floatende (mit keinem festen Potential verbundene) Anschluß des Auswahltransistors T bei den modifizierten Speicherzellen 14 das Potential der entsprechenden Bitleitung BL beim Auslesen kaum, woran ein Datum des zweiten logischen Zustandes 0 zu erkennen ist.

Ist nun die "normale" Wortleitung WL, die die erste Einheit E1 bildet, insgesamt defekt oder weist sie einzelne defekte ROM-Speicherzellen 11 auf (was durch einen Test, der beispielsweise am Ende des Herstellungsprozesses der integrierten Schaltung, aber eventuell auch später durchführbar ist, feststellbar ist), so ist sie im Redundanzfall durch die redundante Wortleitung WL' (zweite Einheit E2) adressenmäßig ersetzbar. Diese zweite Einheit E2 weist nur RAM-Speicherzellen 12 auf. Beim dargestellten Ausführungsbeispiel handelt es sich bei den RAM-Speicherzellen 12 um DRAM-Speicherzellen.

Die ROM-Speicherzellen 11 zum Speichern von Daten des ersten logischen Zustandes 1 sind also genauso aufgebaut wie die RAM-Speicherzellen 12. Die ROM-Speicherzellen 11 als modifizierte Speicherzellen 14 zur Speicherung von Daten des zweiten logischen Zustandes 0 unterscheiden sich dagegen von den RAM-Speicherzellen 12 insofern, als die elektrische Verbindung zwischen dem Auswahltransistor T und dem Speicherzellenkondensator C nicht vorhanden ist.

In vorteilhafter Weise erfolgt bei der erfindungsgemäßen Initialisierung ein Einsatz des Redundanz-Detektionsmittels 4 und des Reparaturmittels 5. Bei jeder Inbetriebnahme des erfindungsgemäßen Speichers ist durch das Redundanz-Detektionsmittel 4 ermittelbar, ob eine und gegebenenfalls welche erste Einheit E1 durch eine der redundanten zweiten Einheiten E2 ersetzt worden ist. Anschließend sind durch das Reparaturmittel 5 in den ersetzenden zweiten Einheiten E2 Daten des korrekten logischen Zustands speicherbar, wie sie eigentlich in den ROM-Speicherzellen 11 der jeweils ersetzten ersten Einheit E1 gespeichert sein sollten. Nach Abschluß dieser, gegenüber der bisher praktizierten Initialisierung eines DROMs verlängerten Initialisierungsphase ist der integrierte Speicher betriebsbereit.

Dadurch, daß sowohl die "normalen" ROM-Speicherzellen 11 als auch die redundanten RAM-Speicherzellen 12 dieselbe Zellstruktur aufweisen, ergibt sich ein sehr einfacher Herstellungsprozeß für den integrierten Speicher. Die Fläche zur Realisierung der redundanten zweiten Einheiten E2 ist sehr gering, da insbesondere die bei diesem Ausführungsbeispiel gezeigten 1-Transistor-DRAM-Speicherzellen einen sehr geringen Platzbedarf aufweisen. Daher eignet sich die Erfindung sehr gut für den Einsatz in DROMs, deren Herstellung bekanntlich durch Abwandlung eines DRAM-Herstellprozesses erfolgt. Allerdings ist die Erfindung nicht auf DROMs begrenzt. Auch müssen die redundanten RAM-Speicherzellen 12 nicht unbedingt 1-Transistor-DRAM-Speicherzellen sein. Es kommen auch andere RAM-Speicherzellen in Betracht.

Die Festwert-Speicherzellen 13 der dritten Einheiten E3 (in Figur 2 nicht dargestellt) können vorteilhafterweise ebenfalls DROM-Speicherzellen wie die ROM-Speicherzellen 11 in Figur 2 sein. Sie können insbesondere Bestandteil desselben Speicherzellenfeldes wie diese sein.

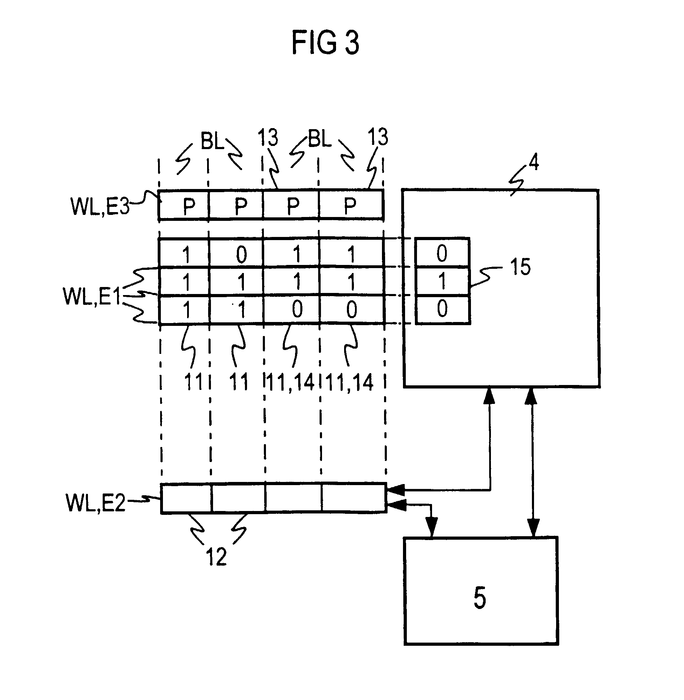

Figur 3 zeigt in einer vereinfachenden Darstellungsform andere Details aus des Speichers aus Figur 1. Es sind drei erste Einheiten E1, die Wortleitungen WL sind, dargestellt. Sie weisen ROM-Speicherzellen 11 auf, von denen einige modifizierte Speicherzellen 14 im oben beschriebenen Sinne sind. Die eingetragenen logischen Zustände 0, 1 sollen bei der gewählten Darstellungsweise nicht den tatsächlichen Speicherzelleninhalt sondern den gewünschten Speicherzelleninhalt bei Fehlerfreiheit der entsprechenden ersten Einheit E1 darstellen. Der gewünschte Speicherzelleninhalt kann vom tatsächlichen Speicherzelleninhalt aufgrund von Fehlern bei der Herstellung der integrierten Schaltung bzw. bei der Programmierung des ROMS abweichen.

In Figur 3 ist auch die zweite Einheit E2 mit redundanten RAM-Speicherzellen 12 gezeigt, die zum Ersetzen einer der ersten Einheiten El im Redundanzfall dient. Die dritte Einheit E3 weist die Festwert-Speicherzellen 13 zum Speichern der Paritätsbits P auf. Die ersten E1, zweiten E2 und dritten E3 Einheiten sind jeweils Wortleitungen WL, WL'.

Im folgenden wird nun die Funktion eines Ausführungsbeispiels des Redundanz-Detektionsmittels 4 und des Reparaturmittels 5 erläutert:

Das Redundanz-Detektionsmittel 4 in Figur 3 enthält ein Festwert-Speichermittel 15, welches ebenso viele Speicherplätze aufweist, wie erste Einheiten E1 vorhanden sind. Durch die gestrichelten Verbindungslinien ist angedeutet, daß jeder Speicherplatz des Festwert-Speichermittels 15 vorteilhafterweise Bestandteil eines der ersten Einheiten E1 sein kann. Im Festwert-Speichermittel 15 sind Informationen gespeichert, die angeben, ob die zugehörige erste Einheit E1 bei fehlerfrei gespeicherten Daten modifizierte Speicherzellen 14 aufweist oder nicht. Wie oben bereits erwähnt, kann es in Folge von Herstellungsfehlern vorkommen, daß statt einer eigentlich herzustellenden modifizierten Speicherzelle 14 eine nicht-modifizierte Speicherzelle 11 erzeugt wird. Die Informationen im Festwert-Speichermittel 15 sind dort gleichzeitig mit der Programmierung des Speichers speicherbar, d.h. in der Regel bei der Herstellung des Speichers.

Beim dargestellten Ausführungsbeispiel ist im Festwert-Speichermittel 15 eine 0 eingetragen, sofern die zugehörige erste Einheit E1 im fehlerfreien Fall eine modifizierte Speicherzelle 14 aufweist. Im Festwert-Speichermittel 15 ist eine 1 gespeichert, wenn die zugehörige erste Einheit E1 bei Fehlerfreiheit keine modifizierten Speicherzellen 14 aufweist.

Da es nun Aufgabe des Redundanz-Detektionsmittels 4 ist, die Adresse einer ersetzten der ersten Einheiten E1 zu ermitteln, um anschließend auf diese Fehlerkorrekturmaßnahmen durch das Reparaturmittel 5 anzuwenden, wird folgendermaßen verfahren:

Jede der Speicherzellen 11, 12 wird mit Daten des ersten logischen Zustandes 1 beschrieben, indem die jeweilige erste Einheit E1 (bzw. im Redundanzfall die zweite Einheit E2 anstelle der jeweils zu ersetzenden ersten Einheit E1) adressiert wird. Handelt es sich bei der ersten Einheit E1 um eine, die ausschließlich nicht-modifizierte Speicherzellen 11 aufweist, ist dies durch das Redundanz-Detektionsmittel 4 anhand der entsprechenden Eintragung im zugehörigen Festwert-Speichermittel 15 erkennbar. Für eine derartige erste Einheit E1 mit nicht-modifizierten ROM-Speicherzellen 11, die sich gemäß Figur 2 in nichts von einer DRAM-Speicherzelle 12 unterscheiden, ist ein Ersetzen im Redundanzfall durch die zweite Einheit E2 mit RAM-Speicherzellen 12 völlig unproblematisch. Die zweite Einheit E2 weist dann nach der bei der Inbetriebnahme des Speichers durchgeführten Initialisierung die dabei eingeschriebenen Daten des ersten logischen Zustandes 1 auf. Damit ist die Rekonstruktion der in diesen redundanten RAM-Speicherzellen 12 gespeicherten Daten bereits abgeschlossen.

Stellt das Redundanz-Detektionsmittel 4 jedoch aufgrund der entsprechenden Eintragungen im Festwert-Speichermittel 15 fest, daß es sich bei der jeweils adressierten ersten Einheit E1 um eine solche handelt, die eigentlich auch modifizierte Speicherzellen 14 beinhalten sollte, ist erfindungsgemäß vorgesehen, nach der Initialisierung des gesamten Speichers mit Daten des ersten logischen Zustandes 1 zumindest alle Speicherzellen dieser ersten Einheiten 1 mit modifizierten Speicherzellen 14 wieder auszulesen. Ergibt sich dabei, daß eine der ersten Einheiten E1 aufgrund der Eintragung im Festwert-Speichermittel 15 eigentlich modifizierte Speicherzellen 14 aufweisen müßte, beim Auslesen der mit der entsprechenden Adresse adressierten Speicherzellen aber nur Daten des ersten logischen Zustandes 1 ausgelesen werden, so steht fest, daß in diesem Fall unter der entsprechenden Adresse eine erste Einheit E1 mit modifizierten Speicherzellen 14 durch die zweite Einheit E2 mit RAM-Speicherzellen 12 ersetzt worden ist (Redundanzfall). Dies liegt daran, daß sich die modifizierten Speicherzellen 14 nicht mit Daten des ersten logischen Zustandes 1 beschreiben lassen, da ihr Speicherzellenkondensator C nicht mit dem Auswahltransistor T in Verbindung steht (siehe Figur 2). Modifizierte Speicherzellen 14 lassen sich aus diesem Grund, wie gesagt, nicht mit Daten des ersten logischen Zustands 1 beschreiben.

Das soeben Beschriebene wird nun noch einmal anhand Figur 3 erläutert:

Ist im Redundanzfall die mittlere der ersten Einheiten E1 in Figur 3, die nur nicht-modifizierte ROM-Speicherzellen 11 aufweist, durch die zweite Einheit E2 ersetzt worden, so ist aufgrund des ersten Teiles der Initialisierung (Beschreiben aller Speicherzellen 11, 12 mit dem ersten logischen Zustand 1) keine weiteren Reparaturmaßnahmen des Dateninhalts der ersetzten ROM-Speicherzellen 11 durch das Reparaturmittel 5 durchzuführen, da dann bereits die korrekten Daten in den redundanten RAM-Speicherzellen 12 gespeichert sind.

Ist im Redundanzfall dagegen in Figur 3 die obere oder untere der ersten Einheiten E1 mit modifizierten Speicherzellen 14 durch die zweite Einheit E2 ersetzt worden, dann ist es notwendig, daß mittels des Reparaturmittels 5 unter Zuhilfenahme von Fehlerkorrekturcodes eine Rekonstruktion des Dateninhaltes der einzelnen ersetzten ROM-Speicherzellen 11 vorgenommen wird und die rekonstruierten Daten in den RAM-Speicherzellen 12 gespeichert werden. Hierbei kann z.B. von den Paritätsbits P in den Festwert-Speicherzellen 13, wie bezüglich Figur 1 erläutert, Gebrauch gemacht werden.

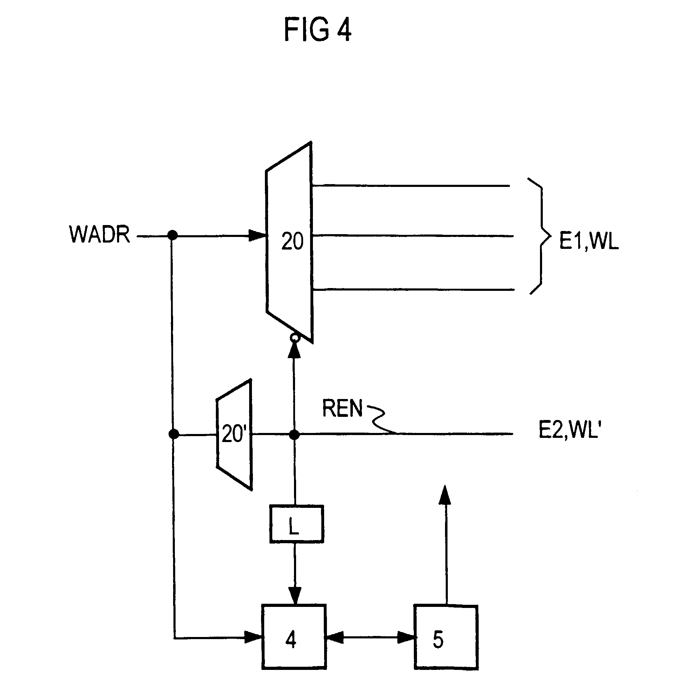

Figur 4 zeigt ein anderes Ausführungsbeispiel von Details des Speichers in Figur 1. Die ersten E1 und zweiten Einheiten E2 sind, wie in Figur 1, "normale" Wortleitungen WL bzw. redundante Wortleitungen WL'. Wortadressen WADR zur Adressierung der normalen Wortleitungen WL sind durch den normalen Wortleitungsdekoder 20 dekodierbar und die entsprechende Wortleitung WL ist so selektierbar. Gleichzeitig ist die Wortadresse WADR durch einen Redundanzwortleitungsdekoder 20 (der in Figur 1 gemeinsam mit dem Wortleitungsdekoder 20 als eine Einheit dargestellt ist) dekodierbar. Ist im Redundanzfall eine der ersten Einheiten E1 durch die zweite Einheit E2 ersetzt worden, ist die entsprechende Wortadresse WADR im Redundanzwortleitungsdekoder 20' programmiert. Dies geschieht üblicherweise mittels trennbarer Verbindungen (fuses) im Anschluß an die Herstellung und eine Test des Speichers. Spricht nun der Redundanzwortleitungsdekoder 20' auf eine angelegte Wortadresse WADR an, erzeugt er ein Redundanz-Aktivierungssignal REN, welches zum einen zu einer Deaktivierung des normalen Wortleitungsdekoders 20 führt und zum anderen zu einer Selektion der entsprechenden redundanten Wortleitung WL'.

Erfindungsgemäß ist nun vorgesehen, das Redundanz-Aktivierungssignal REN heranzuziehen, um mittels des Redundanz-Detektionsmittels 4 die Adressen von ersetzten ersten Einheiten E1 zu ermitteln. Dafür ist durch das Redundanz-Detektionsmittel 4 registrierbar, bei welchen angelegten Wortadressen WADR das Redundanz-Aktivierungssignal REN zur Auswahl der zweiten Einheit E2 durch den Redundanzwortleitungsdekoder 20' erzeugt wird. Auf diese Weise lassen sich die gesuchten Adressen besonders einfach ermitteln, woraufhin anschließend durch das Reparaturmittel 5 die Rekonstruktion der in den zu ersetzenden Speicherzellen gespeicherten Daten und das Speichern dieser Daten in den Speicherzellen der zweiten Einheit E2 durchführbar ist.

Figur 4 zeigt ein Register L, in dem bei Bedarf das Redundanz-Aktivierungssignal REN speicherbar ist. Dies kann notwendig sein, wenn der Prozessor, der die Funktionen des Redundanz-Detektionsmittels 4 und des Reparaturmittels 5 ausübt, nicht multitaskingfähig ist, so daß eine Zwischenspeicherung im Register L vor einer Auswertung des Redundanz-Aktivierungssignal REN durch das Redundanz-Detektionsmittel 4 erfolgt.

Besonders vorteilhaft ist es, bei anderen Ausführungsbeispielen der Erfindung die ersten Einheiten E1 zu Gruppen zusammenzufasse: wobei jeder dieser Gruppen eine dritte Einheit E3 mit Festwert-Speicherzellen 13 zugeordnet ist. Durch eine solche Partitionierung kann selbst mit nur einem Paritätsbit je Gruppe und je Wort- bzw. Bitleitung eine sehr gute Fehlerkorrektur erreicht werden, ohne daß ein komplexerer Fehlerkorrekturcode eingesetzt werden müßte.

Die Erfindung ist nicht nur auf den Ersatz von ROM-Speicherzellen eines DROMs durch DRAM-Speicherzellen beschränkt. Erfindungsgemäß ist generell eine Redundanz von beliebigen ROM-Speicherzellen durch beliebige RAM-Speicherzellen möglich.

Erfindungsgemäß ist es nicht nur möglich, bei einem DROM, welches zweierlei Arten von ROM-Speicherzellen aufweist (nämlich modifizierte und nicht-modifizierte Speicherzellen), für beide Arten von Speicherzellen RAM-Speicherzellen als Redundanz vorzusehen. Darüberhinaus ist die Erfindung auch anwendbar auf Speicher, die sowohl DROM- als auch DRAM-Bereiche aufweisen.

## Patentansprüche

1. Speicherschaltung
- mit einzeln adressierbaren ersten Einheiten (E1) mit ROM-Speicherzellen (11) und wenigstens einer redundanten zweiten Einheit (E2) mit RAM-Speicherzellen (12), die im Redundanzfall zum adressenmäßigen Ersetzen einer der ersten Einheiten (E1) dient,
- mit einem Redundanz-Detektionsmittel (4) zur Ermittlung der Adresse der im Redundanzfall durch die zweite Einheit (E2) ersetzten ersten Einheit (E1)
- mit einem Reparaturmittel (5) zur anschließenden Ermittlung von in ersetzten der ROM-Speicherzellen (11) ursprünglich zu speichernden Daten und zum Speichern dieser Daten in den sie ersetzenden RAM-Speicherzellen (12),
- bei der die RAM-Speicherzellen (12) einen Auswahltransistor (T) und einen mit diesem elektrisch verbundenen Speicherkondensator (C) aufweisen,
- bei der diejenigen der ROM-Speicherzellen (11), die zum Speichern von Daten eines ersten logischen Zustands (1) dienen, identisch wie die RAM-Speicherzellen (12) aufgebaut sind
- und bei der diejenigen der ROM-Speicherzellen (11), die zum Speichern von Daten eines zweiten logischen Zustands (0) dienen, modifizierte Speicherzellen (14) sind, die sich von den RAM-Speicherzellen (12) darin unterscheiden, daß bei ihnen die elektrische Verbindung zwischen dem Auswahltransistor (T) und dem Speicherkondensator (C) unterbrochen ist.

2. Speicherschaltung nach Anspruch 1,
- die eine adressierbare dritte Einheit (E3) mit Festwert-Speicherzellen (13) aufweist, in denen Paritätsbits (P) gespeichert sind,
- und bei der die Ermittlung der in den ersetzten ROM-Speicherzellen (11) ursprünglich zu speichernden Daten durch das Reparaturmittel (5) mittels Fehlerkorrekturcodes unter Verwendung der Paritätsbits (P) erfolgt.

3. Speicherschaltung nach Anspruch 1 oder 2,
- bei der zur Ermittlung, ob eine der ersten Einheiten (E1) mit modifizierten Speicherzellen (14) im Redundanzfall durch die zweite Einheit (E2) ersetzt worden ist, Daten des ersten logischen Zustands (1) in alle Speicherzellen (11; 12) eingeschrieben und wieder ausgelesen werden, die durch Anlegen der Adresse (WADR) dieser ersten Einheit (E1) mit modifizierten Speicherzellen (14) adressiert werden,
- und bei der anschließend ein Vergleich zwischen den eingeschriebenen und ausgelesenen Daten erfolgt,
-- wobei nur bei Übereinstimmung der eingeschriebenen mit den ausgelesenen Daten die Ermittlung der ursprünglich zu speichernden Daten und das Speichern dieser Daten in den der jeweiligen Adresse (WADR) entsprechenden Speicherzellen erfolgt.

4. Speicherschaltung nach Anspruch 3,
bei der das Redundanz-Detektionsmittel (4) ein Festwert-Speichermittel (15) aufweist, in dem gespeichert ist, welche der ersten Einheiten (E1) bei Fehlerfreiheit modifizierte Speicherzellen (14) enthalten.

5. Speicherschaltung nach einem der vorstehenden Ansprüche, bei der zur Ermittlung der Adresse der ersetzten der ersten Einheiten (E1) dem Redundanz-Detektionsmittel (4) ein durch einen Redundanzdecoder (20') erzeugtes, zur Aktivierung der zweiten Einheit (E2) dienendes Redundanz-Aktivierungssignal (REN) zugeführt wird.

## Claims

1. Memory circuit
- having individually addressable first units (E1) having ROM memory cells (11) and at least one redundant, second unit (E2) having RAM memory cells (12), which second unit serves for address replacement of one of the first units (E1) in the event of redundancy,
- having a redundancy detection means (4) for determining the address of the first unit (E1) which is replaced by the second unit (E2) in the event of redundancy,
- having a repair means (5) for subsequently determining data to be stored originally in replaced cells of the ROM memory cells (11), and for storing said data in the RAM memory cells (12) replacing them,
- in which the RAM memory cells (12) have a selection transistor (T) and a storage capacitor (C) electrically connected thereto,
- in which those of the ROM memory cells (11) which serve to store data of a first logic state (1) are constructed identically to the RAM memory cells (12),
- and in which those of the ROM memory cells (11) which serve to store data of a second logic state (0) are modified memory cells (14), which differ from the RAM memory cells (12) in that the electrical connection between the selection transistor (T) and the storage capacitor (C) is interrupted in the case of said modified memory cells.

2. Memory circuit according to Claim 1,
- which has an addressable third unit (E3) having read-only memory cells (13), in which parity bits (P) are stored,
- and in which the determination of the data to be stored originally in the replaced ROM memory cells (11) by the repair means (5) is effected by means of error correction codes using the parity bits (P) .

3. Memory circuit according to Claim 1 or 2,
- in which, in order to determine whether one of the first units (E1) having modified memory cells (14) has been replaced by the second unit (E2) in the event of redundancy, data of the first logic state (1) are written to, and read out again from, all the memory cells (11; 12), which are addressed by application of the address (WADR) of this first unit (E1) having modified memory cells (14),
- and in which a comparison between the data written in and read out is subsequently effected,
-- the determination of the data to be stored originally and the storage of these data in the memory cells corresponding to the respective address (WADR) only being effected in the event of correspondence between the data written in and the data read out.

4. Memory circuit according to Claim 3,
in which the redundancy detection means (4) has a read-only memory means (15), in which is stored the information regarding which of the first units (E1) contain modified memory cells (14) in the event of freedom from errors.

5. Memory circuit according to one of the preceding claims,
in which, in order to determine the address of the replaced units of the first units (E1), a redundancy activation signal (REN) is fed to the redundancy detection means (4), which redundancy activation signal is generated by a redundancy decoder (20') and serves to activate the second unit (E2).

## Revendications

1. Circuit mémoire
- avec des premières unités (E1), qui peuvent être adressées individuellement, avec des cellules de mémoire ROM (11) et avec au moins une deuxième unité redondante (E2) avec des cellules de mémoire RAM (12), qui sert, en cas de redondance, au remplacement du point de vue de l'adressage de l'une des premières unités (E1),
- avec un moyen (4) de détection de la redondance pour la détermination de l'adresse de la première unité (E1) remplacée, en cas de redondance, par la deuxième unité (E2),
- avec un moyen (5) de réparation pour déterminer, immédiatement après, des données, destinées à l'origine à être stockées dans les cellules de mémoire ROM (11) remplacées, et pour stocker ces données dans les cellules de mémoire RAM (12) qui les remplacent,
- dans lequel les cellules de mémoire RAM (12) comportent un transistor (T) de sélection et un condensateur (C) de mémorisation, qui lui est raccordé électriquement,
- dans lequel celles des cellules de mémoire ROM (11), qui sont destinées à stocker des données d'un premier état logique (1), sont conçues de la même façon que les cellules de mémoire RAM (12) et
- dans lequel celles des cellules de mémoire ROM (11), qui sont destinées à stocker des données d'un deuxième état logique (0), sont des cellules de mémoire modifiées (14) qui se distinguent des cellules de mémoire RAM (12) par le fait que, dans celles-ci, la liaison électrique entre le transistor (T) de sélection et le condensateur (C) de mémorisation est interrompue.

2. Circuit mémoire selon la revendication 1,
- qui comporte une troisième unité adressable (E3) avec des cellules de mémoire à valeur fixe (E3), dans lesquelles sont stockés des bits de parité (P) et
- dans lequel la détermination des données destinées à l'origine à être stockées dans les cellules de mémoire ROM (11) remplacées est effectuée par le moyen (5) de réparation à l'aide de codes de correction d'erreurs en faisant appel à des bits de parité (P).

3. Circuit mémoire selon la revendication 1 ou 2
- dans lequel, pour déterminer si une des premières unités (E1) avec des cellules de mémoire modifiées (14) a été remplacée, en cas de redondance, par la deuxième unité (E2), des données du premier état logique (1) sont écrites dans toutes les cellules de mémoire (11, 12), puis relues sur ces cellules de mémoire (11, 12), qui sont adressées par application de l'adresse (WADR) de cette première unité (E1) avec des cellules de mémoire modifiées (14), et
- dans lequel, immédiatement après, une comparaison est effectuée entre les données écrites et les données relues,
-- la détermination des données destinées à l'origine à être stockées et le stockage de ces données dans les cellules de mémoire correspondant à l'adresse (WADR) respective n'ayant lieu que si les données écrites et les données relues concordent.

4. Circuit mémoire selon la revendication 3
dans lequel le moyen (4) de détection de la redondance comporte un moyen de mémorisation à valeur fixe (15), dans lequel sont mémorisées, celles des premières unités (E1) qui, en cas d'absence d'erreur, contiennent des cellules de mémoire modifiées (14).

5. Circuit mémoire selon l'une des revendications précédentes
dans lequel, pour la détermination de l'adresse des unités remplacées parmi les premières unités (E1), est appliqué, sur le moyen (4) de détection de la redondance, un signal (REN) d'activation de la redondance, généré par un décodeur de redondance (20') et servant à activer la deuxième unité (E2).
